# EUROPEAN PATENT SPECIFICATION

(11) **EP 2 070 116 B1**
(45) Date of publication and mention of the grant of the patent: **23.11.2016**
(21) Application number: 07818455.3
(22) Date of filing: 26.09.2007
(51) Int. Cl.: H01L 25/075, H05K 1/14, F21S 2/00

(54) **MODULAR BACKLIGHTING DEVICE**
MODULARE RÜCKBELEUCHTUNGSEINRICHTUNG
DISPOSITIF DE RÉTROÉCLAIRAGE MODULAIRE

(30) Priority: 28.09.2006 ES 200602189 U
(43) Date of publication of application: 17.06.2009
(73) Proprietor: Sakma Electronica Industrial, S.A., 08907 Hospitalet de Llobregat, Barcelona (ES)
(72) Inventor: SANABRA CUNILL, Angel, 08015 Barcelona (ES)
(74) Representative: Sugrañes Patentes y Marcas
(86) International application number: PCT/EP2007/008371
(87) International publication number: WO 2008/037450

(56) References cited:
- EP-A- 1 033 535
- EP-A- 1 742 522
- EP-A1- 1 617 239
- WO-A-2006/040937
- DE-A1- 19 848 078
- US-A- 4 969 827
- US-A- 5 660 461
- US-A1- 2004 012 957
- US-A1- 2005 169 007
- US-A1- 2006 221 612
- US-A1- 2007 242 477

## Description

### Object of the invention

The present invention refers to a modular backlighting device of the type which includes various lighting elements arranged on a panel or support board, to illuminate a large or small surface.

### Background of the invention

At present, the use of different lighting elements, such as fluorescent tubes, halogen lamps, incandescent bulbs or high power LEDs is very common for the lighting of surfaces and different spaces. These lighting elements, used independently, illuminate a reduced or particular space; however, there are many applications which seek to illuminate spaces or large surfaces as evenly as possible and to minimise the shaded areas. This type of lighting is especially suitable in photographic studios, lighting of posters and signs, light boxes, art galleries, and in other applications in which illumination is, either direct, or from the back when the surface being illuminated is translucent.

Presently, to achieve as even lighting as possible, lighting panels are used, which consist of a support board on which various lighting elements are mounted, usually fluorescent tubes, arranged in a parallel fashion and spaced evenly. These fluorescent panels do not provide even lighting across the surface with more light visible around the areas where the fluorescent tubes are housed and other darker areas in the middle section. To solve this problem two compromise solutions exist. The first solution is to increase the number of fluorescent tubes in the panel, so that they are closer to one another, offering more even light, however this increases energy consumption. Another solution is the placement above the fluorescent tubes of a diffuser distanced sufficiently from the fluorescent tubes, so that a larger diffusion of light is obtained and less contrast between the lighter and darker areas. This solution produces a noticeable decrease in intensity, meaning that more fluorescent tubes of higher intensity and consumption have to be fitted.

In some cases the means of lighting can be neon and even light emitting diodes (LEDs) distributed in square matrixes.

Another type of lighting panel known and used especially in signs to provide more even light is for a transparent metacryolite board provided with a few channels arranged in bas-relief and illuminated, at least, at one end by an alignment of LEDs whose light falls on the walls of the channels defined in the lateral surface of the board projecting it towards the front area. This type of panels have many disadvantages, among which it is necessary to emphasize the need to use a high number of LEDs, very close to one another, forming the end alignments, which cause problems of dissipation of heat and an important reduction of the useful life of the LEDs, or the limitation of the dimensions of the board to obtain suitable lighting, since the light projected from the side attenuates as it travels from the source, causing poor or uneven light at short distances (up to 50 cm).

EP 1033525 describes a flexible multiple LED module having a plurality of rigid printed circuit boards, which are each connected at one of their main surfaces to a flexible printed circuit board with a spacing between one another, and a plurality of LEDs, which are mounted in the region of the rigid printed circuit boards on the flexible printed circuit board.

US 2005/169007 describes a backlight unit for a liquid crystal display. The backlight unit includes a light source having a plurality of basic cell structures. Each basic cell structure consists of three unique colors of first, second, and third light emitting diodes, arranged in a first equilateral triangle.

WO 2006/040937 discloses boards housing a number of light emitting diodes arranged on each board according to an equilateral triangular distribution forming light source units with three green light emitting diodes, two red light emitting diodes, and two blue light emitting diodes. These seven light emitting diodes are used as to form two light source units for backlight mixing three primary color light (R, G, B) emitted from the seven light emitting diodes. A color liquid crystal display panel of the transmissive color liquid crystal display device is illuminated from the rear side by the backlight device for liquid crystal display composed of the plurality of light source units.

### Description of the invention

The modular backlighting device object of this invention presents various particular features designed to allow the conformation of a lighting panel without dimensional limitations and to provide even lighting without appreciable shadows or dark areas.

This modular backlighting device is applicable both in direct lighting and in lighting from behind or backlighting of panels or surfaces or translucent bodies.

In accordance with the invention, the modular device comprises an unspecified number of printed circuit boards of equal size to which are connected a large number of light emitting diodes arranged according to an equilateral triangular matrix and separated from one another at a fixed distance "a".

Each of the boards is equipped with various interlocking slot sections on both edges which are used as a guide for centring and enabling the attachment of successive boards, as in a jigsaw puzzle, so that larger lighting panels can be created.

The triangular equilateral distribution of the light emitting diodes in the boards determines that the beams of light emitted by said diodes converge at a certain distance "d" of the board providing from the above mentioned distance a surface or even mass of light without points or apreciable zones of shade.

The distance "d" from which the device provides even lighting without shadow depends on the distance "a" existing between the light emitting diodes and on the aperture or angle of the beam of light emitted by the diodes, therefore the mentioned distance "d" can be reduced using diodes with a larger angle of aperture or reducing the existing separation between said diodes, that is to say the distance "a".

The possibility of reducing the distance "d", from which the device provides even light (without shadows) provides this lighting device with some ideal characteristics for those applications in which it is necessary to project uniform lighting onto posters, signs, photographs or any translucent element, and in areas of reduced space or limited end section.

The housing boards of the light emitting diodes have various openings for assembly and rapid attachment to any surface by means of clamps, screws or any other conventional means.

One of the characteristics of the device is that the light emitting diodes are arranged in the boards in such a way that on having done the panelling or side connection of successive boards, the light emitting diodes of the above mentioned boards support the triangular equilateral distribution and the distance "a" between said diodes, which allows the creation of much larger lighting surfaces of completely even light, without shadows or areas of deficient lighting in the joints of the successive boards.

The boards have connectors or contact points for the interconnection of the respective circuits printed in the position of connecting or panelling and the simultaneous supply to all of the boards in the device.

In accordance with the invention, the boards can have tear lines, defined by pre scored areas, to allow a controlled separation of the board and to obtain smaller sizes of the board, of varying dimensions which can be used independently or connected to a panel formed by two or more interconnected boards. The above mentioned tear lines are arranged in such a way that each of the portions obtained by the separation of the board will have a group of light emitting diodes connected electrically by the conductive tracks of the printed circuit. The portions of board obtained by means of controlled separation at the tear lines allow a better dimensional adjustment of the lighting device within the space or available surface in every specific application.

### Description of the drawings

To complement the description being undertaken and in order to ease understanding of the characteristics of the invention, the present description contains a set of drawings in which, with illustrative and not limitative character, the following has been represented:

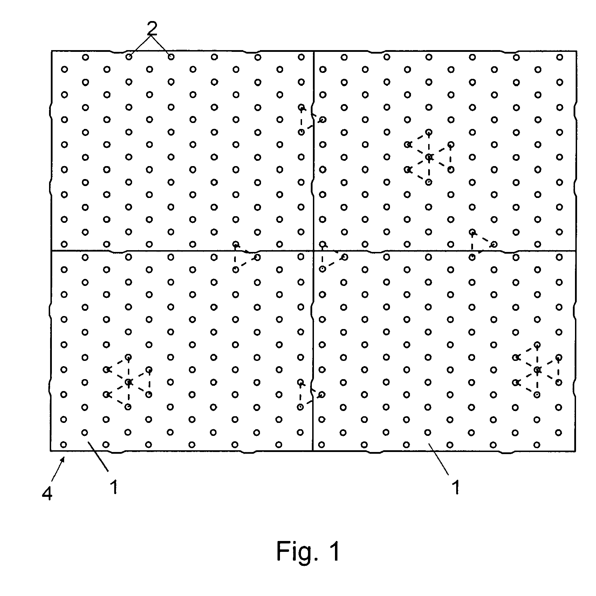

- Figure 1 shows a schematic elevated view from the front of the device comprising a lighting panel containing four housing boards of light emitting diodes, connected side by side and in which it is possible to observe the conservation of the triangular equilateral arrangement of the light emitting diodes in the connecting areas of the boards
- Figure 2 shows a schematic elevated view of one of the boards in figure 1, provided in this case with score lines for the controlled separation of the board into usable pieces of various sizes

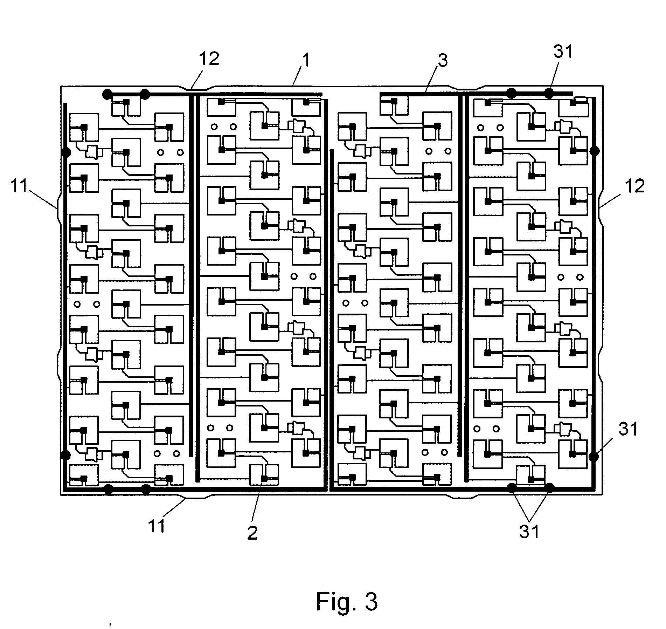

- Figure 3 shows a front elevated view of an example of embodiment of one of the boards, in which the printed connecting circuit board is represented.
- Figure 4 shows a schematic, partial side view of one of the boards in which the beams of light emitted by one of the rows of diodes are represented. This figure shows the beams of light that illuminate a point arranged to a distance "d" of the front of the board as a continuous line, and the adjacent beams of light that do not illuminate the mentioned point are represented as broken lines.
- Figure 5 represents a front view of the beams of light emitted by the diodes of one of the boards which are cut at a distance "d" by a cross-section parallel to the board, the above mentioned board provides even light, as can be seen in this figure, the effect of the beams of light of four of the diodes on the point of reference represented in the previous figure.
- Figure 6 shows an analogous view to the figure 4, in which the beams of light are represented as continuous lines which converge on a point placed to a distance "d1" of the board.

### Preferred embodiments the invention

As can be observed in the indexed figures, the device includes an indeterminate number of boards (1) all equal, each being housings of light emitting diodes (2) arranged according to a triangular equilateral distribution, separated at distance "a" and connected electrically with conductive tracks to a printed circuit (3).

The light emitting diodes (2) project beams of light towards the front of the board which, from a distance "d", overlap or interlace partially, providing even and uniform lighting which lacks both shadows and dark areas. The distance "d", as previously mentioned, depends on the angle of aperture of the beam of light emitted by the light emitting diodes and on the separation "a" existing between said light emitting diodes (2).

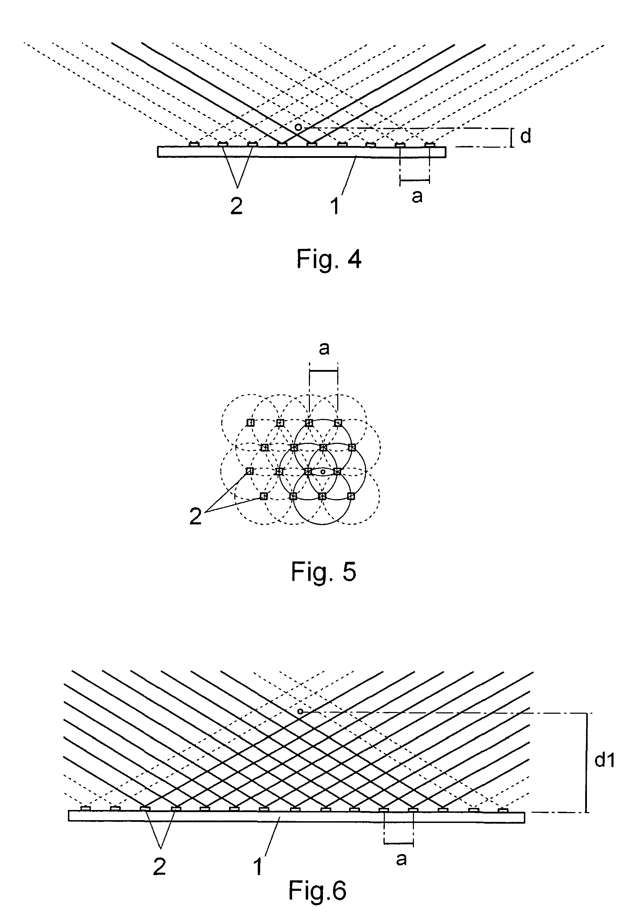

As can be observed in figures 4 and 5, any point arranged to an equal distance or over in relation to "d" is lit by, at least, three light emitting diodes which provide uniformity in the entire surface being lit.

As the distance "d" is increased, as shown in figure 6, in which a point above distance "d1" is represented, the number of light emitting diodes (2) that light every point increases progressively, which allows for even lighting and prevents excessive loss of brightness owed precisely to the increase of the number of light emitting diodes (2) lighting the same point.

The boards (1) contain interlocking slot sections (11) (12) at their outer edges that allow for correct alignment of successive boards (1) to form a lighting panel (4) with a larger surface. The placement of the diodes (2) in each of the boards is such that, on connecting two boards (1), the diodes (2) of the above mentioned boards maintain the triangular equilateral distribution at the joining section and the separation "a", avoiding the formation of shadows or areas of deficient lighting.

The above mentioned boards (1) also include openings (13) for the assembly of clamps, screws or similar means of attachment to any suitable surface. The printed circuits (3) of each one of the boards (1) have contacts or connectors (31) to establish the electrical connection of successive boards when a lighting panel is conformed or to connect an electrical supply source.

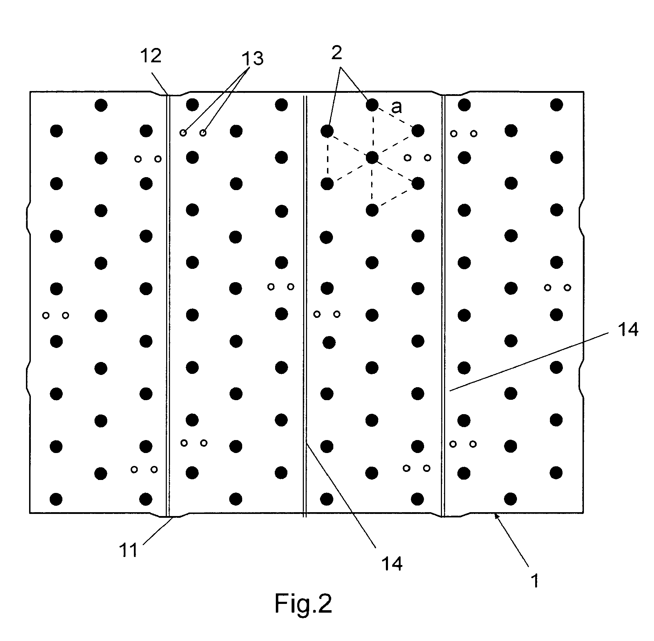

As shown in the example of embodiment in figure 2, the boards (1) can be equipped with tear lines (14) defined by scored lines of material, to ease the controlled separation of the board (1) into usable pieces of varying dimensions, said tear lines being distributed in such a way that each of the portions of board has a group of diodes (2) connected electrically by the conductive tracks of a printed circuit (3).

Having sufficiently described the nature of the invention, as well as an example of preferred embodiment, it is hereby certified that the materials, form, size and arrangement of the described elements will be able to be modified, only when it does not suppose an alteration of the essential characteristics of the invention that are claimed hereafter.

## Claims

1. Modular backlighting device; comprising an unspecified number of housing boards (1) housing a number of light emitting diodes (2) connected electrically with the tracks of a printed circuit (3) arranged on the board separated at fixed distance (a), said light emitting diodes being arranged on the board according to an equilateral triangular distribution, said light emitting diodes projecting beams of light that converge from a certain distance (d) of the board, providing the device from the above mentioned distance (d) a mass of even light, without dark areas or shadows; **characterised in that** the light emitting diodes of the consecutive boards maintain on the joining area of said boards (1) the equilateral triangular distribution and the fixed separation (a).

2. Modular backlighting device, according to claim 1, **characterised in that** each housing board (1) has an essential rectangular shape, having two pairs of opposing edges, the equilateral triangular distribution of the light emitting diodes (2) of said housing board being arranged such that when reaching any of the edges of said housing board, said equilateral triangular distribution continues from the corresponding opposing edge of the same housing board.

3. Modular backlighting device according to any of the preceding claims, **characterised in that** it further comprises a panel, surface, or translucent body illuminated through the light emitting diodes (2) of the housing boards (1).

4. Modular backlighting device according to any of the preceding claims, **characterised in that** the printed circuits (3) of the boards (1) have connectors (31) for the interconnection of printed circuits of successive boards.

5. Modular backlighting device according to any of the preceding claims, **characterised in that** each of the boards (1) is equipped, on each side, with interlocking outer sections (11) and inner sections (12) for the guiding, centring of, and connection to the assembly of successive boards (1), similar to a jigsaw puzzle, used to conform a much larger lighting panel (4).

6. Modular backlighting device according to any of the preceding claims, **characterized in that** the boards (1) contain tear lines (14) defined by scored areas of material, for the controlled separation of the board (1) into usable pieces, of varying dimensions, provided with respective groups of light emitting diodes (2) connected electrically by the conductive tracks of the printed circuit (3).

## Patentansprüche

1. Modulare Rückbeleuchtungseinrichtung; umfassend eine nicht spezifizierte Anzahl von Tragplatten (1), welche eine Anzahl von Leuchtdioden (2) tragen, welche an den Spuren einer gedruckten Schaltung (3) elektrisch verbunden und auf der Platte mit einem festen Abstand (a) getrennt angeordnet sind, wobei die genannten Leuchtdioden auf der Platte gemäß einer gleichseitigen Dreiecksverteilung angeordnet sind, wobei die genannten Leuchtdioden Lichtbündel projizieren, welche in einem bestimmten Abstand (d) von der Platte entfernt zusammenlaufen, sodass die Einrichtung aus dem obengenannten Abstand (d) eine Masse aus gleichmäßigem Licht, ohne dunkle Bereiche oder Schatten bereitgestellt wird; **dadurch gekennzeichnet, dass** die Leuchtdioden der nachfolgenden Platten auf dem Fügebereich der genannten Platten (1) die gleichseitige Dreiecksverteilung und den festen Abstand (a) erhalten.

2. Modulare Rückbeleuchtungseinrichtung nach Anspruch 1, **dadurch gekennzeichnet, dass** jede Tragplatte (1) eine im Wesentlichen rechteckige Form aufweist, mit zwei Paaren von entgegengesetzten Ränder, wobei die gleichseitige Dreiecksverteilung der Leuchtdioden (2) der genannten Tragplatte derart angeordnet ist, dass wenn einer der Ränder der genannten Tragplatte erreicht wird, die genannte gleichseitige Dreiecksverteilung vom entsprechenden entgegengesetzten Rand der gleichen Tragplatte aus weitergeht.

3. Modulare Rückbeleuchtungseinrichtung nach einem der vorhergehenden Ansprüche, **dadurch gekennzeichnet, dass** sie zusätzlich ein Paneel, eine Fläche oder einen lichtdurchlässigen Körper umfasst, beleuchtet durch die Leuchtdioden (2) der Tragplatten (1).

4. Modulare Rückbeleuchtungseinrichtung nach einem der vorhergehenden Ansprüche, **dadurch gekennzeichnet, dass** die gedruckten Schaltungen (3) der Platten (1) Verbinder (31) aufweisen, für die gegenseitige Verbindung von gedruckten Schaltungen von aufeinanderfolgenden Platten.

5. Modulare Rückbeleuchtungseinrichtung nach einem der vorhergehenden Ansprüche, **dadurch gekennzeichnet, dass** jede der Platten (1), auf jeder Seite, mit ineinandergreifenden Außenabschnitten (11) und Innenabschnitten (12) ausgerüstet ist, zum Führen, Zentrieren von, und Verbindung mit der Baugruppe von aufeinanderfolgenden Platten (1), ähnlich wie ein Puzzle, dazu verwendet, einem viel größeren Beleuchtungspaneel (4) zu entsprechen.

6. Modulare Rückbeleuchtungseinrichtung nach einem der vorhergehenden Ansprüche, **dadurch gekennzeichnet, dass** die Platten (1) Reißlinien (14) enthalten, welche durch geritzte Materialbereiche definiert sind, zur gesteuerten Trennung der Platte (1) in nutzbare Stücke, mit verschiedenen Ausmaßen, versehen mit jeweiligen Gruppen von Leuchtdioden (2), welche durch die leitenden Spuren der gedruckten Schaltung (3) elektrisch verbunden sind.

## Revendications

1. Dispositif de rétroéclairage modulaire, comprenant un nombre indéfini de cartes de logements logeant un nombre de diodes électroluminescentes (2) connectées électriquement aux pistes d'un circuit imprimé (3) aménagé sur la carte séparée à une distance fixe (a), lesdits diodes électroluminescentes étant aménagées sur la carte selon une distribution triangulaire équilatérale, lesdits diodes électroluminescentes projetant des rayons lumineux qui convergent à partir d'une certaine distance (d) de la carte, le dispositif fournissant à partir de distance (d) précitée une masse de lumière homogène, sans zones sombres ou ombres; **caractérisé en ce que** les diodes électroluminescentes des cartes consécutives maintiennent sur la zone de liaison desdites cartes (1), la distribution triangulaire équilatérale et la séparation fixe (a).

2. Dispositif de rétroéclairage modulaire, selon la revendication 1, **caractérisé en ce que** chaque carte de logement (1) a une forme rectangulaire essentielle, ayant deux paires de bords opposés, la distribution triangulaire équilatérale des diodes électroluminescentes (2) de ladite carte de logement étant aménagée de manière que lorsque qu'elle atteint l'un quelconque des bords de ladite carte de logement, ladite distribution triangulaire équilatérale continue à partir du bord opposé correspondant de la même carte de logement.

3. Dispositif de rétroéclairage modulaire, selon l'une quelconque des revendications précédentes, **caractérisé en ce qu'il** comprend en outre un panneau, une surface, ou corps translucide éclairé à travers les diodes électroluminescentes (2) des cartes de logements.

4. Dispositif de rétroéclairage modulaire, selon l'une quelconque des revendications précédentes, **caractérisé en ce que** les circuits imprimés (3) des cartes (1) ont des connecteurs (31) pour l'interconnexion des circuits imprimés des cartes successives.

5. Dispositif de rétroéclairage modulaire, selon l'une quelconque des revendications précédentes, **caractérisé en ce que** chacune des cartes (1) est équipé, de chaque côté, de sections extérieures d'enclenchement (11) et des sections intérieures (12) pour le guidage, centrage de, et la connexion à l'ensemble de cartes successives (1), similaire à un casse-tête, utilisé pour conformer un panneau d'éclairage beaucoup plus grand (4).

6. Dispositif de rétroéclairage modulaire, selon l'une quelconque des revendications précédentes, **caractérisé en ce que** les cartes (1) contiennent des lignes de déchirure (14) définies par des zones de pointage de matière, pour la séparation contrôlée de la carte (1) en des pièces utilisables, de dimensions variables, pourvues de groupes respectifs de diodes électroluminescentes (2) connectées électriquement par des pistes conductrices du circuit imprimé (3).
